# EUROPÄISCHE PATENTSCHRIFT

(11) **EP 2 210 458 B1**
(45) Veröffentlichungstag und Bekanntmachung des Hinweises auf die Patenterteilung: **16.08.2017**
(21) Anmeldenummer: 08849471.1
(22) Anmeldetag: 12.11.2008
(51) Int. Cl.: G06F 1/18, H05K 7/14

(54) **ANORDNUNG MIT EINER ELEKTRONISCHEN KOMPONENTE UND EINEM TRÄGER**
ARRANGEMENT HAVING AN ELECTRONIC COMPONENT AND A CARRIER
ENSEMBLE AVEC UN COMPOSANT ELECTRONIQUE ET UN SUPPORT

(30) Priorität: 12.11.2007 DE 102007053837; 19.11.2007 DE 102007055141
(43) Veröffentlichungstag der Anmeldung: 28.07.2010
(73) Patentinhaber: Siemens Aktiengesellschaft, 80333 München (DE)
(72) Erfinder: KRZOSKA, Andreas, 76149 Karlsruhe (DE)
(86) Internationale Anmeldenummer: PCT/EP2008/065345
(87) Internationale Veröffentlichungsnummer: WO 2009/062941

(56) Entgegenhaltungen:
- US-A- 6 101 088
- US-A1- 2006 143 877
- US-B1- 6 257 682

## Beschreibung

Die Erfindung betrifft einen Träger zur Aufnahme und Halterung einer im Wesentlichen quaderförmigen elektronischen Komponente gemäß dem Oberbegriff des Patentanspruchs 1.

Aus dem Siemens-Katalog ST PC, Ausgabe April 2007, Seite 3/29 ist ein u-förmiger Träger in Form eines Buchmontage-Kits bekannt, in welchen eine elektronische Komponente in Form eines Rechners eingeschoben und befestigt werden kann. Mittels dieses Trägers ist es möglich, den Rechner in einen Schaltschrank einzubauen. Die Schenkel (Flansche) des Trägers sind mit lochförmigen Ausnehmungen versehen, durch die der Rechner mittels Schrauben an den Träger montierbar ist, wobei der Rechner entsprechende Gewindebohrungen aufweist, in welche die Schrauben eingeschraubt werden. Die Basis (Steg) des u-förmigen Trägers ist so dimensioniert, dass ein Rechner zwar leicht in diesen Träger eingeschoben werden kann, allerdings sind Unterlegscheiben erforderlich, um den Abstand zwischen dem jeweiligen Schenkel des u-förmigen Trägers und der jeweiligen Seitenwand des Rechners im Bereich der lochförmigen Ausnehmungen der Schenkel auszugleichen. Dies bedeutet einerseits einen erhöhten Montageaufwand, andererseits muss im Rahmen einer Ersatzteilhaltung eine Vielzahl von Unterlegscheiben gelagert werden.

US 2006/0143877 A1 beschreibt einen federnden Kontakt mit einem oberen Federarm und einer Klemmplatte, wobei der Kontakt z. B. die Lücke bzw. den Spalt zwischen zwei übereinander angeordneten Festplatten-Laufwerken eines Mainframe-Servers überbrückt.

US 6,101,088 offenbart ein tragbares elektronisches Gerät mit einem Gestell, wobei konstruktive Maßnahmen vorgesehen sind, um unterschiedliche Funktionskomponenten in verschiedenen Einbauplätzen innerhalb des Gestells anzuordnen.

Ein Träger mit den im Oberbegriff des Anspruchs 1 angegebenen Maßnahmen ist aus US 6,257,682 B1 bekannt.

Der vorliegenden Erfindung liegt die Aufgabe zugrunde, einen Träger der eingangs genannten Art zu schaffen, durch welchen eine Montage einer elektronischen Komponente in den Träger vereinfacht wird.

Diese Aufgabe wird durch die im kennzeichnenden Teil des Anspruchs 1 angegebenen Maßnahmen gelöst.

Vorteilhaft ist die vereinfachte Montage bzw. Demontage der elektronischen Komponente, z. B. eine elektronische Komponente in Form eines Rechners, in bzw. aus dem Träger; die Servicefreundlichkeit wird erhöht. Es sind keine zusätzlichen Teile zum Ausgleich des Abstandes zwischen dem jeweiligen Schenkel des u-förmigen Trägers und der jeweiligen Seitenwand des Rechners im Bereich der lochförmigen Ausnehmungen der Schenkel (Toleranzausgleich) erforderlich. Lediglich im Bereich der lochförmigen Ausnehmungen wird der jeweilige Schenkel durch das Befestigen des Rechners an dem Schenkel deformiert, wodurch mechanische Spannungen zwischen dem Träger und dem Rechner weitgehend vermieden werden. Die Verbindung des Rechners mit dem Träger ist sehr robust, insbesondere der durch die zweite u-förmige Ausnehmung begrenzte Bereich liegt im montierten Zustand des Rechners im Träger im Wesentlichen bündig und spaltfrei an der Seitenwand des Rechners an.

Die bündige und spaltfreie Verbindung wird insbesondere dadurch verbessert, dass die lochförmige Ausnehmung als ein Langloch ausgebildet ist.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen in schematischer Darstellung:
- Figur 1: einen Ausschnitt eines Trägers und
- Figuren 2 und 3: einen Ausschnitt einer Anordnung mit einem Träger und einem Rechner.

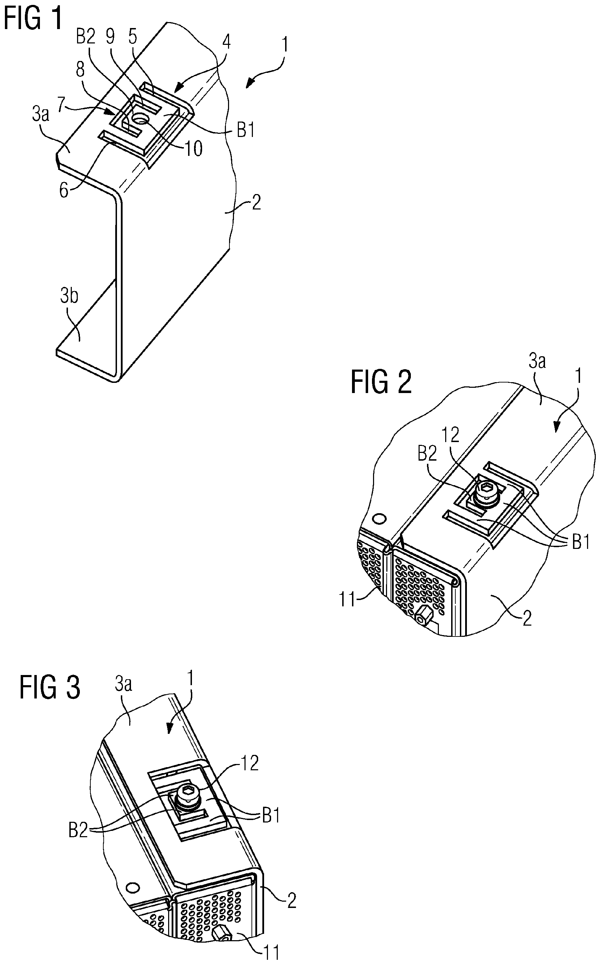

In Figur 1 ist mit 1 ein Träger bezeichnet, welcher im Wesentlichen u-förmig mit einer Basis (Steg) 2 und Schenkeln (Flansch) 3a, 3b ausgebildet ist. Der Träger 1 ist zur Aufnahme und Halterung eines im Wesentlichen quaderförmigen Rechners vorgesehen, wobei die Basis 2 des u-förmigen Trägers 1 so dimensioniert ist, dass der Rechner zwischen die Schenkel 3a, 3b des Trägers 1 einschiebbar ist. Für den Fall, dass der Rechner in den Träger 1 eingeschoben ist, kann der Rechner in dem Träger 1 befestigt werden. Dazu weist mindestens einer der Schenkel 3a, 3b des Trägers 1, im dargestellten Beispiel der Schenkel 3a, mindestens eine erste u-förmige Ausnehmung 4 auf, wobei in einem durch Schenkel 5, 6 dieser u-förmigen Ausnehmung 4 begrenzten Bereich B1 eine zu dieser um 180° gedrehte zweite u-förmige Ausnehmung 7 vorgesehen ist. In einem praktischen Ausführungsbeispiel der Erfindung weist jeder der Schenkel 3a, 3b jeweils zwei erste und zweite u-förmige Ausnehmungen 4, 7 auf, wodurch eine sehr gute Befestigung des Rechners im Träger 1 bzw. eine sehr gute mechanische Verbindung dieser beiden Teile bewirkt wird.

Innerhalb eines durch Schenkel 8, 9 der zweiten u-förmigen Ausnehmung 7 begrenzten Bereiches B2 ist eine lochförmige Ausnehmung 10 in Form eines Langloches vorgesehen, durch welche der Rechner mittels eines Befestigungselementes an dem Träger 1 befestigt werden kann. Das Befestigungselement kann z. B. in Form einer Schraube ausgebildet sein, wobei in diesem Fall der Rechner mit einer entsprechenden Gewindebohrung versehen ist, in welche die Schraube eingeschraubt werden kann.

In diesem Zusammenhang wird auf die Figuren 2 und 3 verwiesen, in denen ein Ausschnitt einer Anordnung mit einem Träger und einem Rechner dargestellt ist.

Die in den Figuren 1 bis 3 dargestellten gleichen Teile sind mit gleichen Bezugszeichen versehen.

Ein Rechner 11 ist mittels einer Schraube 12 an dem Träger 1 befestigt, wobei durch das Einschrauben der Bereich B2 der zweiten u-förmigen Ausnehmung 7 bündig auf der Seitenwand des Rechners 11 aufliegt. Dies bedeutet, dass der Abstand zwischen der Seitenwand des Rechners 11 und dem Bereich B2, welcher erforderlich ist, um den Rechner 11 in den Träger 1 leicht einschieben zu können, durch das Einschrauben auf Null vermindert wird. Nur die Bereiche B1, B2 sind durch das Einschrauben deformiert, ansonsten bleibt der Schenkel 3a, 3b im Hinblick auf seine Geometrie unverändert, der Winkel zwischen dem Schenkel 3a, 3b und der Basis 2 des Trägers 1 ändert sich durch das Festschrauben des Rechners 11 in den Träger 1 nicht.

## Patentansprüche

1. Träger zur Aufnahme und Halterung einer im Wesentlichen quaderförmigen elektronischen Komponente (11), wobei der Träger (1) im Wesentlichen u-förmig ausgebildet ist und eine Basis (2) und zwei Schenkel (3a, 3b) aufweist, wobei
- mindestens ein Schenkel (3a) des Trägers (1) mindestens eine erste u-förmige Ausnehmung (4) aufweist,
- ein durch die Schenkel (5, 6) der ersten u-förmigen Ausnehmung (4) begrenzter Bereich (B1) vorgesehen ist,
- eine lochförmige Ausnehmung (10) vorgesehen ist, durch welche die elektronische Komponente (11) mittels eines Befestigungselementes (12) an dem Träger (1) befestigt ist,
**dadurch gekennzeichnet, dass**
- im begrenzten Bereich (B1) der ersten u-förmigen Ausnehmung (4) eine zu dieser ersten Ausnehmung (4) um 180° gedrehte zweite u-förmige Ausnehmung (7) vorgesehen ist,
- die lochförmige Ausnehmung (10) innerhalb eines durch die Schenkel (8, 9) der zweiten u-förmigen Ausnehmung (7) begrenzten Bereiches (B2) vorgesehen ist.

2. Träger nach Anspruch 1, **dadurch gekennzeichnet, dass** die lochförmige Ausnehmung (10) als ein Langloch ausgebildet ist.

## Claims

1. Carrier for receiving and holding a substantially cuboid electronic component (11), wherein the carrier (1) is substantially embodied u-shaped and has a base (2) and two limbs (3a, 3b), wherein
- at least one limb (3a) of the carrier (1) has at least one first u-shaped recess (4),
- a region (B1) delimited by the limbs (5, 6) of the first u-shaped recess (4) is provided,
- a hole-shaped recess (10) is provided, by means of which the electronic component (11) is fastened to the carrier (1) by means of a fastening element (12),
**characterised in that**
- a second u-shaped recess (7) which is rotated by 180° relative to the first recess (4) is provided in the delimited region (B1) of the first u-shaped recess (4),
- the hole-shaped recess (10) is provided within a region (B2) delimited by the limbs (8, 9) of the second u-shaped recess (7).

2. Carrier according to claim 1, **characterised in that** the hole-shaped recess (10) is embodied as an elongated hole.

## Revendications

1. Support de réception et de fixation d'un composant (11 ) électronique sensiblement parallélépipédique, le support (1 ) étant sensiblement en forme de u et ayant une base (2 ) et deux branches (3a, 3b), dans lequel
- au moins un branche (3a ) du support (1 ) a au moins un premier évidement (4 ) en forme de u,
- il est prévu une partie (B1 ) délimitée par les branches (5, 6) du premier évidement (4) en forme de u,
- il est prévu un évidement (10) en forme de trou, par lequel le composant (11) électronique est fixé au support, au moyen d'un élément (12) de fixation,
**caractérisé en ce que**
- dans la partie (B1) délimitée du premier évidement (4) en forme de u, est prévu un deuxième évidement (7) en forme de u, à 180° par rapport à ce premier évidement (4),
- l'évidement (10) en forme de trou est prévu à l'intérieur d'une partie (B2) délimitée par les branches (8, 9) du deuxième évidement (7) en forme de u.

2. Support suivant la revendication 1, **caractérisé en ce que** l'évidement (10) en forme de trou est constitué sous la forme d'une boutonnière.
